(19) Europäisches Patentamt / European Patent Office / Office européen des brevets

(11) **EP 3 292 229 B1**

(12) **FASCICULE DE BREVET EUROPEEN**

(45) Date de publication et mention de la délivrance du brevet:
**16.09.2020 Bulletin 2020/38**

(21) Numéro de dépôt: **16723432.7**

(22) Date de dépôt: **22.04.2016**

(51) Int Cl.:
*H01J 37/32* (2006.01)     *H01J 37/34* (2006.01)
*C23C 16/04* (2006.01)     *C23C 16/26* (2006.01)
*C23C 16/511* (2006.01)    *C23C 16/52* (2006.01)

(86) Numéro de dépôt international:
**PCT/FR2016/050956**

(87) Numéro de publication internationale:
**WO 2016/177953 (10.11.2016 Gazette 2016/45)**

(54) **INSTALLATION POUR LE TRAITEMENT DE RÉCIPIENTS PAR PLASMA MICRO-ONDES, COMPRENANT UN GÉNÉRATEUR A ÉTAT SOLIDE ET PROCÉDÉ DE RÉGLAGE**

ANLAGE ZUR BEHANDLUNG VON BEHÄLTERN DURCH MIKROWELLENPLASMA MIT EINEM FESTKÖRPERGENERATOR UND ANPASSUNGSVERFAHREN

FACILITY FOR TREATING CONTAINERS BY MICROWAVE PLASMA, COMPRISING A SOLID-STATE GENERATOR AND ADJUSTMENT METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.05.2015 FR 1553966**

(43) Date de publication de la demande:
**14.03.2018 Bulletin 2018/11**

(73) Titulaire: **Sidel Participations**
**76930 Octeville-sur-Mer (FR)**

(72) Inventeurs:
• **DUCLOS, Yves-Alban**
  **76930 Octeville-Sur-Mer (FR)**
• **TURLOTTE, Denis**
  **76930 Octeville-Sur-Mer (FR)**

(74) Mandataire: **Grassin d'Alphonse, Emmanuel Jean Marie**
**Sidel Participations**
**Avenue de la Patrouille de France**
**76930 Octeville-sur-mer (FR)**

(56) Documents cités:
EP-A1- 1 881 088     WO-A1-2012/146870
WO-A2-2007/006977    JP-A- 2006 336 095

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

Printed by Jouve, 75001 PARIS (FR)

EP 3 292 229 B1

**Description**

L'invention a trait au traitement des récipients en polymère (tel que PET) par plasma, et plus précisément par dépôt chimique en phase vapeur assisté par plasma, d'une couche mince - typiquement (mais non exclusivement) de carbone amorphe hydrogéné.

Un carbone amorphe hydrogéné est un matériau comprenant des atomes de carbone et d'hydrogène, que l'on désigne couramment par la formule a-C:H, qui apparaît au centre du diagramme ternaire d'équilibre carbone-hydrogène, tel qu'illustré notamment dans l'Encyclopédie Ullmann de l'industrie chimique, 5e éd., Vol. A26, p.720.

Les couches (ou films) minces (d'une épaisseur comprise entre 0,050 $\mu$m et 0,200 $\mu$m) de carbone amorphe hydrogéné ont la propriété de former une barrière notamment aux ultraviolets, aux molécules d'oxygène et de dioxyde de carbone. En l'absence d'une telle couche barrière, les ultraviolets et l'oxygène traversent la paroi du récipient et sont susceptibles d'en corrompre le contenu, notamment la bière ou le thé. Quant au dioxyde de carbone des boissons carbonatées (dites gazeuses), il a également tendance à s'échapper par migration au travers de la paroi du récipient.

Classiquement, et comme décrit notamment dans le brevet européen EP 1 068 032 (Sidel Participations) ou dans le brevet japonais JP 2006-336095 (Toppan Printing), pour former une couche mince sur la paroi interne d'un récipient, on commence par introduire le récipient dans une enceinte placée dans une cavité conductrice et transparente à l'essentiel du spectre micro-ondes.

On dépressurise ensuite à la fois le récipient et l'enceinte pour obtenir, d'une part, dans le récipient, un vide poussé (de quelques $\mu$bars - rappelons que 1 $\mu$bar = $10^{-6}$ bar) nécessaire à l'établissement du plasma et, d'autre part, dans l'enceinte à l'extérieur du récipient, un vide moyen (de l'ordre de 30 mbar à 100 mbar), pour éviter que le récipient ne se contracte sous l'effet de la différence de pression de part et d'autre de sa paroi.

Puis on injecte dans le récipient un gaz précurseur (typiquement un hydrocarbure sous forme gazeuse, tel que de l'acétylène, $C_2H_2$), puis on génère dans la cavité (et donc dans l'enceinte) un champ électromagnétique de micro-ondes pour activer (et entretenir pendant une durée prédéterminée, généralement de l'ordre de quelques secondes) dans le gaz un plasma qui dissocie les molécules du gaz puis les recombine en diverses espèces (notamment CH, $CH_2$, $CH_3$ dans le cas d'un hydrocarbure tel que l'acétylène) qui se déposent en couche mince sur la paroi interne du récipient.

Dans les procédés connus, les micro-ondes sont généralement produites par un magnétron, relié à la cavité par un guide d'onde. Cette technique, éprouvée, ne va toutefois pas sans inconvénient.

Pour que ces micro-ondes soient correctement diffusées dans la cavité (et donc dans l'enceinte), la fréquence de résonance de celle-ci doit correspondre à un pic de fréquence d'émission du magnétron. Or, non seulement le pic de fréquence des micro-ondes produites par un magnétron n'est pas réglable, mais ce pic, qui se trouve dans un spectre d'émission assez large (de l'ordre de 50 MHz) n'est pas non plus tout à fait stable, car il dépend notamment de facteurs qui peuvent varier, tels que la température, la tension électrique ou encore l'intensité du courant de commande.

Comme, en pratique, les caractéristiques dimensionnelles des cavités et les fréquences d'émission des magnétrons présentent des légères variations, l'assemblage des machines de traitement des récipients par plasma comprend donc nécessairement une opération d'appariement de chaque cavité à un magnétron.

Statistiquement, seul un magnétron sur quatre convient à une cavité donnée : on comprend donc que l'assemblage d'une machine de traitement de récipients par plasma n'est pas simple. Un mauvais appariement conduit à une mauvaise activation et/ou un mauvais entretien du plasma, qui peut notamment connaître des clignotements ou des baisses d'intensité, d'où il résulte un mauvais traitement des récipients qui doivent en conséquence être mis au rebut. "Par ailleurs, le document WO2012/146870 décrit un générateur à état solide. Le document WO02007/006977 décrit un appareil pour déposer une couche mince comprenant un spectrometre."

Un premier objectif est de proposer une solution permettant de fiabiliser les machines de traitement des récipients par plasma.

Un deuxième objectif est de proposer une solution permettant de simplifier l'assemblage des machines de traitement des récipients par plasma.

Un troisième objectif est d'améliorer la qualité du traitement par plasma des récipients.

Un quatrième objectif est de permettre une meilleure activation et un meilleur entretien du plasma.

A cet effet, il est proposé, en premier lieu, une installation pour le dépôt chimique en phase vapeur assisté par plasma, sur une paroi interne d'un récipient en polymère, d'une couche barrière mince, qui comprend :

- une cavité conductrice ;
- une enceinte montée dans la cavité ;
- un dispositif d'injection d'un gaz précurseur dans l'enceinte ;
- un générateur de micro-ondes ;
- un dispositif de diffusion des micro-ondes dans l'enceinte, relié au générateur de micro-ondes, pour exciter et entretenir un plasma dans le gaz précurseur ;

cette installation étant caractérisée :

- en ce que le générateur de micro-ondes est un générateur à état solide, équipé d'un variateur de fréquence d'émission des micro-ondes ;
- en ce qu'elle comprend un capteur disposé de façon à mesurer une grandeur physique caractérisant l'intensité énergétique du plasma produit dans le récipient
- en ce qu'elle comprend une unité de contrôle reliée au capteur et au générateur de micro-ondes, cette unité de contrôle étant programmée pour ajuster la fréquence d'émission des micro-ondes, par l'intermédiaire du variateur de fréquence, en fonction de la valeur de la grandeur physique caractérisant l'intensité énergétique mesurée par le capteur.

Diverses caractéristiques supplémentaires peuvent être prévues, seules ou en combinaison :

- la grandeur physique mesurée est la luminosité du plasma et le capteur est un capteur de luminosité dirigé vers l'enceinte afin de mesurer la luminosité au travers de la paroi de l'enceinte et celle du récipient ;
- la grandeur physique mesurée est la concentration massique des espèces contenues dans le plasma et le capteur est un spectromètre ;
- la grandeur physique mesurée est la pression du plasma et le capteur est un capteur de la pression régnant dans le récipient ;
- le dispositif de diffusion des micro-ondes se présente sous forme d'une antenne ;
- l'antenne s'étend au travers de la cavité et fait saillie dans celle-ci ;
- l'antenne forme une boucle dans la cavité ;
- les dimensions de la boucle formée par l'antenne sont du même ordre de grandeur que la demi-longueur d'onde des micro-ondes produites par le générateur ;
- le dispositif de diffusion des micro-ondes est relié au générateur par un câble coaxial.

Il est proposé, en deuxième lieu, un procédé de réglage d'une installation telle que présentée ci-dessus, qui comprend les opérations consistant à :

- introduire un récipient dans l'enceinte ;
- injecter le gaz précurseur dans le récipient ;
- générer dans l'enceinte, au moyen du générateur de micro-ondes, un champ électromagnétique à une fréquence d'émission prédéterminée de façon à exciter un plasma dans le gaz précurseur ;
- mesurer, au moyen, du capteur une grandeur physique caractérisant l'intensité énergétique du plasma produit dans le récipient ;
- tant que la grandeur physique caractérisant l'intensité énergétique du plasma produit dans l'enceinte diffère d'une valeur de référence prédéterminée, ajuster la fréquence d'émission des micro-ondes au moyen de l'unité de contrôle agissant sur le variateur de fréquence.

Selon d'autres caractéristiques du procédé, prises seules ou en combinaison :

- la grandeur physique mesurée est proportionnelle à la valeur de l'intensité énergétique ; la grandeur physique mesurée est la luminosité du plasma ; la grandeur physique mesurée est la concentration massique des espèces contenues dans le plasma ;
- la grandeur physique mesurée est inversement proportionnelle à l'intensité énergétique ; la grandeur physique mesurée est la pression régnant dans le récipient.

D'autres objets et avantages de l'invention apparaîtront à la lumière de la description d'un mode de réalisation, faite ci-après en référence aux dessins annexés dans lesquels :

- la figure 1 est une vue en coupe, partiellement schématique, d'une installation de traitement de récipients par plasma, comprenant un poste de traitement d'un récipient ;
- la figure 2 est une vue d'un détail, à échelle agrandie, du poste de traitement montré sur la figure 1, suivant l'encart II ;
- la figure 3 est une vue en coupe partielle, à échelle agrandie, du poste de traitement montré sur la figure 1 ;
- la figure 4 est un diagramme illustrant l'architecture fonctionnelle de l'installation de traitement de la figure 1 ;
- la figure 5 est un diagramme sur lequel est tracée une courbe correspondant aux variations de luminosité dans le récipient au cours du temps.

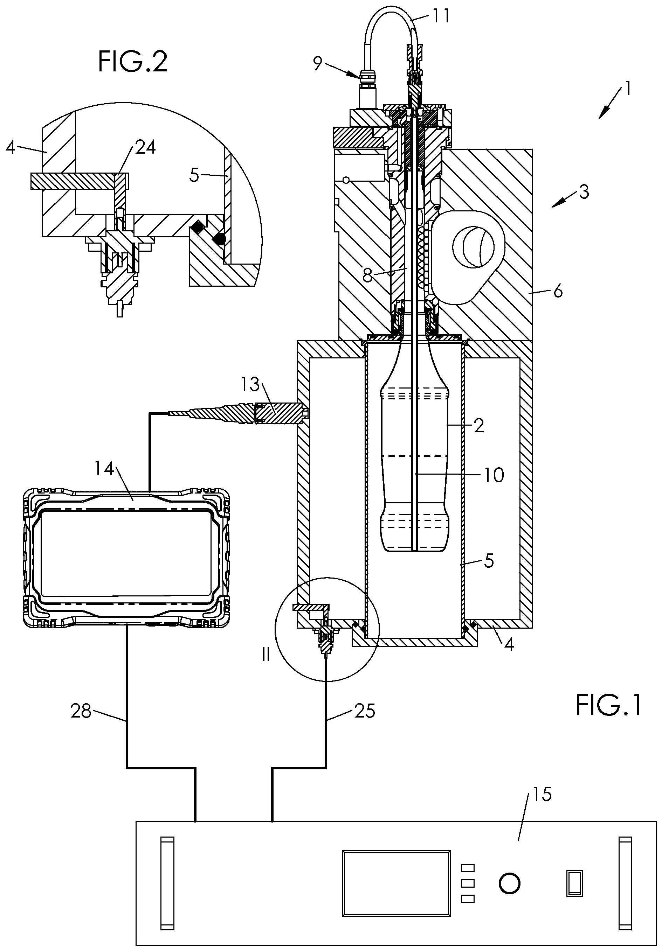

Sur la figure 1 est partiellement représentée une installation **1** pour le traitement de récipients **2** en polymère par dépôt chimique en phase vapeur assisté par plasma, sur une paroi interne des récipients **2**, d'une couche barrière mince.

Chaque récipient **2** à traiter (typiquement une bouteille ou un flacon) présente sa forme finale ; il a par exemple été formé par soufflage ou étirage soufflage à partir d'une préforme. Selon un mode particulier de réalisation, le récipient **2** est réalisé en PET (polytéréphtalate d'éthylène).

La couche à déposer peut être composée de carbone amorphe hydrogéné, qui présente l'avantage de former une barrière aux gaz tels que l'oxygène et le dioxyde de carbone, auxquels le PET seul est relativement perméable. D'autres types de couches minces que celles à base de carbone peuvent convenir, pour les mêmes applications, notamment à base d'oxyde de silicium ou d'aluminium.

L'installation **1** comprend une pluralité de postes **3** de traitement tous semblables, chacun configuré pour accueillir et traiter un seul récipient **2** à la fois. L'installation **1** comprend en outre une structure (de préférence tournante, telle qu'un carrousel) sur laquelle sont montés les postes **3** de traitement, qui sont par exemple au nombre de vingt-quatre, ou encore de quarante-huit, de sorte à permettre un traitement des récipients **2** à cadence industrielle (de l'ordre de plusieurs dizaines de milliers par heure).

Chaque poste **3** de traitement comporte une cavité **4** externe de forme avantageusement cylindrique, réalisée dans un matériau conducteur, par exemple métallique (typiquement en acier ou, de préférence, en aluminium ou dans un alliage d'aluminium), et dimensionnée pour permettre l'établissement en son sein d'une onde électromagnétique stationnaire à une fréquence de résonance prédéterminée dans le domaine des microondes, et plus précisément proche de 2 450 MHz (ou 2,45 GHz).

Chaque poste **3** de traitement comprend en outre une enceinte **5** tubulaire, montée de manière coaxiale et étanche dans la cavité **4** et réalisée dans un matériau transparent à un large spectre électromagnétique. Plus précisément, l'enceinte **5** est transparente au moins au domaine visible et aux micro-ondes. Selon un mode de réalisation, le matériau dans lequel est réalisée l'enceinte **5** est du quartz.

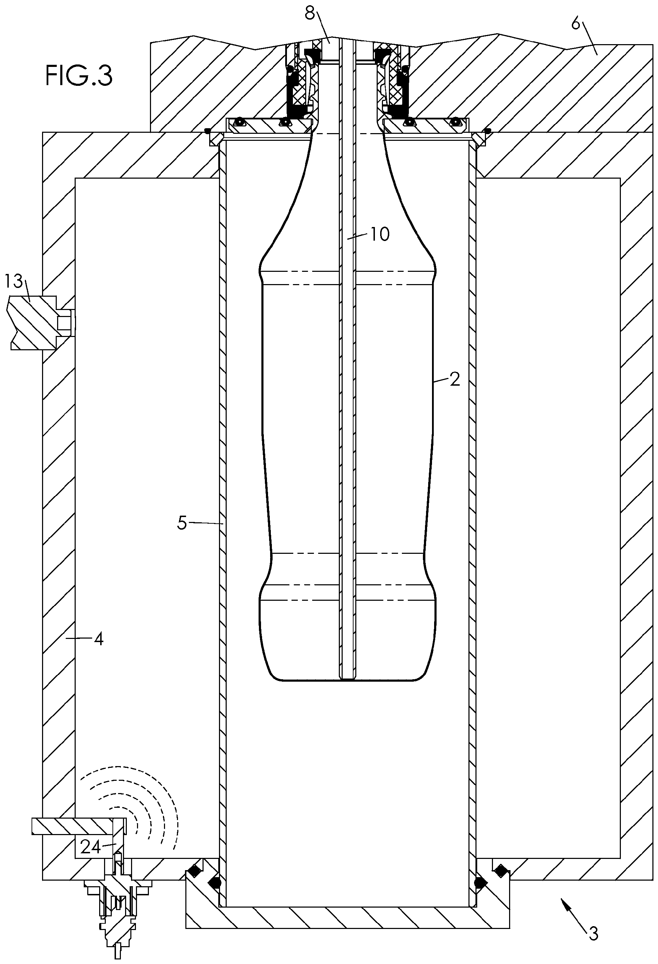

Selon un mode de réalisation particulier illustré sur la figure 3, l'enceinte **5** est, à une extrémité supérieure, emboîtée de manière étanche dans une ouverture formée dans une paroi supérieure de la cavité **4**, celle-ci étant surmontée d'un couvercle **6**.

A une extrémité inférieure, l'enceinte **5** coopère de manière étanche avec un fond amovible permettant d'introduire, par le bas, un récipient **2** dans l'enceinte **5** pour permettre son traitement, et son retrait après la fin du traitement.

Le poste **3** de traitement est muni d'un support (par exemple de type fourchette) qui coopère avec un col du récipient **2** pour assurer la suspension de celui-ci dans l'enceinte **5**, et divers joints qui assurent l'étanchéité du volume interne du récipient **2** vis-à-vis de l'enceinte **5**.

Sont ainsi séparés de manière étanche :

- l'intérieur du récipient **2**,
- l'extérieur du récipient **2** dans l'enceinte **5**,
- l'extérieur de l'enceinte **5** dans la cavité **4**.

Pour plus de détail sur la réalisation de l'étanchéité, l'homme du métier pourra se référer à la description de la demande de brevet US 2010/0007100.

Le poste **3** de traitement comprend :

- un circuit primaire de vide comprenant une pompe **7** à vide primaire permettant de faire un vide poussé (de l'ordre de quelques microbars) dans le récipient **2**, via une tuyère **8** formée dans le couvercle **6** et débouchant dans le récipient **2** (lorsque celui-ci est présent), et
- un circuit secondaire de vide comprenant une pompe à vide secondaire permettant de faire un vide moyen (de l'ordre de quelques millibars) dans l'enceinte **5** à l'extérieur du récipient **2**, pour éviter que celui-ci ne se contracte sous l'effet de la différence de pression de part et d'autre de sa paroi.

Le poste **3** de traitement comprend également un dispositif **9** d'injection, dans l'enceinte **5**, d'un gaz précurseur tel que de l'acétylène (de formule $C_2H_2$). Dans l'exemple illustré, ce dispositif **9** comprend un injecteur **10** tubulaire relié, via un flexible **11** et une électrovanne **12** commandée, à une source (non représentée) de gaz précurseur.

Pour plus de détail concernant la structure de la cavité **4**, l'homme du métier pourra se référer à la description de la demande de brevet US 2010/0206232 (Sidel Participations).

Le poste **3** de traitement comprend également au moins un capteur **13** associé à l'enceinte **5** et apte à réaliser une mesure d'une grandeur physique caractérisant l'intensité énergétique d'un plasma amorcé dans le gaz précurseur.

Selon un mode particulier de réalisation illustré sur les figures, le capteur **13** est un capteur de luminosité. La luminosité est directement proportionnelle à l'intensité énergétique du plasma. L'enceinte **5**, transparente au domaine visible du spectre électromagnétique, ne forme pas obstacle à la diffusion de la lumière issue du plasma et n'affecte donc pas (ou peu) la mesure.

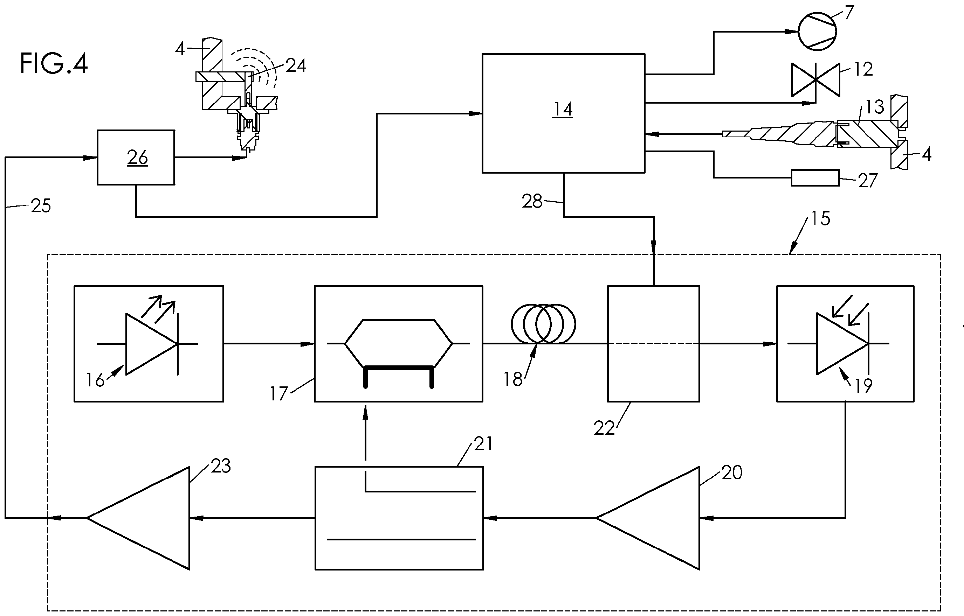

Le capteur **13** peut être monté sur la paroi de la cavité **4**. Comme on le voit sur la figure 4, le capteur **13** est relié à une unité **14** de contrôle qui en collecte les mesures. L'unité **14** de contrôle est informatisée (sous forme d'un automate programmable, d'un ordinateur ou plus simplement d'un processeur) ; elle peut être propre au poste **3** de traitement ou commune à l'ensemble de ceux-ci (à condition que sa puissance de calcul soit suffisante).

En variante, le capteur **13** peut être un spectromètre (de masse, optique ou encore ionique), capable de mesurer les concentrations massiques des différentes espèces contenues dans le plasma (et donc d'en déduire l'intensité énergétique de celui-ci), ou un capteur de pression (celle-ci étant inversement proportionnelle à l'intensité du plasma). Dans ce dernier cas, le capteur est monté sur la tuyère **8**.

Le poste **3** de traitement comprend par ailleurs un générateur **15** d'ondes électromagnétiques dans le domaine des micro-ondes. Il s'agit d'un générateur dit à « *état solide* ».

L'expression « *état solide* », peu usitée en Français, est une traduction littérale de l'expression anglaise « *solid state* », employée couramment depuis des décennies dans le domaine de l'électronique, et plus particulièrement dans le domaine de l'ingénierie des radiofréquences, comme le montrent les ouvrages suivants :

- Herbert L. Kraus et al. « Solid State Radio Engineering », éd. John Wiley & Sons, 1980,
- Stephen F. Adam, « Microwave theory and applications », Englewood cliffs, 1969

- Owen E. Maynard, « Solid State SPS Microwave Generation and Transmission Study », NASA Scientific and technical, 1980.

D'une manière générale, l'expression « état solide » caractérise un état de la matière dans lequel les atomes, les molécules ou les ions sont liés entre eux en sorte qu'en l'absence de contrainte mécanique ils sont fixes les uns par rapport aux autres. En électronique, l'expression « *état solide* » désigne les circuits fabriqués à l'aide de matériaux solides et dans lesquels les électrons ou autres charges porteuses d'un signal sont confinés dans ces matériaux. Aujourd'hui, ces circuits sont plus couramment appelés « circuits intégrés », ou « circuits à semiconducteurs », mais l'expression « état solide » est demeurée pour caractériser certains dispositifs électroniques complexes.

Ainsi, un générateur de micro-ondes à état solide désigne un dispositif de génération d'un signal électrique dans la gamme de fréquence des micro-ondes, dans lequel le signal est généré par un circuit intégré, par contraste avec les technologies plus anciennes (mais toujours employées) des tubes à vide (employés notamment dans les générateurs de type magnétron).

Des générateurs dits à « état solide » sont disponibles sous cette désignation dans le commerce, voir par ex. :

- chez SAIREM, le générateur de micro-ondes à état solide de modèle GMS 200W, qui fournit un signal micro-onde à fréquence centrale de 2 450 MHz, réglable entre 2 430 et 2 470 MHz, pour une puissance de sortie maximale de 200 W ;
- chez MKS, le générateur de micro-ondes à état solide de modèle SG 524, qui fournit un signal micro-onde à fréquence centrale de 2 450 MHz, réglable entre 2 400 et 2 500 MHz, pour une puissance de sortie maximale de 450 W.

Il n'entre pas dans le cadre du présent exposé de fournir une description précise d'un générateur de micro-ondes à état solide, puisque, comme nous venons de le voir, des modèles de tels générateurs existent dans le commerce et peuvent être intégrés sans adaptation particulière à la présente installation.

Cependant, il peut sembler utile, pour une meilleure compréhension des phénomènes en jeu, de fournir une description succincte de l'architecture d'une forme possible de réalisation du générateur **15** de micro-ondes à état solide, en référence à la figure 4.

Ce générateur **15** est de type optoélectronique, mais cette technologie n'est nullement limitative. On pourrait ainsi employer un générateur à oscillateur LC à transistor, dont l'inductance est variable (ce qui permet de faire varier la fréquence des micro-ondes générées).

Quoi qu'il en soit, dans l'exemple illustré, le générateur **15**, de type optoélectronique, comprend, en premier lieu, les composants suivants :

- une diode **16** photoémettrice, par ex. une diode laser à onde entretenue ou CW (Continuous wave), qui convertit un signal électrique d'alimentation en un signal lumineux non modulé en intensité ;
- un modulateur **17** à semi-conducteur (de type Mach-Zehnder par exemple), qui module en intensité le signal lumineux non modulé issu de la diode **16** photoémettrice ;
- un guide **18** d'onde optique, dans lequel est injectée la lumière modulée par le modulateur **17** ; ce guide **18** d'onde comprend par exemple une fibre optique ;
- un photorécepteur **19** à semi-conducteur, tel qu'une diode MSM (métal-semi-conducteur-métal), qui capte le signal lumineux modulé issu du guide **18** d'onde et le convertit en signal électrique ;
- éventuellement un préamplificateur **20** à semi-conducteur (de préférence à transistor à effet de champ, par ex. à transistor MESFET - transistor métal-semi-conducteur à effet de champ), qui affecte à la puissance du signal électrique issu du photorécepteur **19** un coefficient de proportionnalité supérieur à 1 ;
- un coupleur **21**, qui prélève une partie du signal électrique issu du photorécepteur **19** (éventuellement amplifié par le préamplificateur **20**) pour le réinjecter dans le modulateur **17** (qui se trouve ainsi asservi), de sorte à former une boucle de rétroaction qui provoque une oscillation entretenue du signal optique issu du modulateur **17** (et donc du signal électrique issu du photorécepteur **19**).

Ces composants forment ainsi, ensemble, un oscillateur qui fournit, en sortie, un signal électrique périodique dont la fréquence se situe dans le domaine des micro-ondes. Plus précisément, selon un mode préféré de réalisation, les composants sont choisis pour que la fréquence soit dans la bande 2 400 MHz - 2 500 MHz de l'ISM (Industriel, Scientifique, Médical) tel que défini par la norme EN 55011.

Comme on le voit sur la figure 4, le guide **18** d'onde comprend un variateur **22** de fréquence constitué par une section à longueur variable qui, en modifiant la longueur du chemin parcouru par le signal lumineux, induit une variation de sa fréquence. En d'autres termes, la section à longueur variable du guide d'onde forme un variateur **22** de fréquence pour le signal issu de l'oscillateur, de sorte à couvrir la gamme 2 400 MHz - 2 500 MHz. Le variateur **22** de fréquence est relié à l'unité **14** de contrôle.

Le générateur **15** comprend, en deuxième lieu, un amplificateur **23** qui reçoit le signal électrique issu de l'oscillateur pour lui appliquer un coefficient de proportionnalité (supérieur à 1) et ainsi augmenter sa puissance. L'amplificateur **23** est du type à semi-conducteur. Il s'agit par exemple d'un circuit à transistor. Selon un mode préféré de réalisation, cet amplificateur **23** comprend un transistor à effet de champ, tel qu'un transistor MOSFET (transistor à effet de champ à structure métal-oxyde-semi-conducteur).

Le poste **3** de traitement comprend, ensuite, un dispositif **24** de diffusion des micro-ondes dans la cavité **4** (et donc dans l'enceinte **5**, transparente aux micro-ondes), relié au générateur **2** par un câble **25** coaxial branché en sortie de l'oscillateur ou, lorsqu'il existe, de l'amplificateur **23**. Selon un mode de réalisation illustré sur les figures 1 à 4, ce dispositif **24** de diffusion se présente sous forme d'une antenne qui s'étend au travers de la paroi de la cavité **4** et fait saillie dans celle-ci. L'antenne **24**, montée à l'extrémité du câble **25** coaxial opposée au générateur **15**, a pour fonction de convertir le signal électrique reçu du générateur **15** (et relayé par le câble **25** coaxial) en un champ électrique micro-ondes dans la cavité **4**.

Comme on le voit bien sur les figures 2 et 3, cette antenne **24**, réalisée dans un matériau métallique (par ex. en cuivre ou en aluminium), forme une boucle dans la cavité **4** pour réaliser avec celle-ci un couplage magnétique. Les dimensions de cette boucle sont du même ordre de grandeur que la demi-longueur d'onde du signal (la longueur d'onde est de l'ordre de 12,2 cm).

La propagation des micro-ondes dans la cavité **4** est libre, et les réflexions sur les parois de la cavité **4** produisent une superposition d'ondes incidentes et réfléchies, et l'établissement dans la cavité **4**, pour certaines fréquences, d'un champ électrique micro-ondes stationnaire, dont la distribution spatiale n'est pas uniforme et qui présente dans certaines zones des concentrations locales d'énergie. Différents modes de propagation (dits modes résonants) sont susceptibles de produire un champ stationnaire. Ces modes résonants diffèrent les uns des autres par la localisation spatiale, dans la cavité **4**, des concentrations d'énergie.

Les modes résonants dépendent de la fréquence d'émission des micro-ondes dans la cavité **4** et de la géométrie de celle-ci, qui en l'espèce est cylindrique. On connaît relativement bien les modes résonants pour cette géométrie, ce qui présente l'avantage de correctement sélectionner un premier mode résonant, dit mode injecteur, permettant de réaliser une concentration énergétique micro-ondes autour de l'injecteur **10** en l'absence de récipient et de plasma.

Ce mode injecteur permet d'obtenir ensuite, par approches successives et par variation de la fréquence des micro-ondes, un deuxième mode résonant (dit mode récipient) permettant de réaliser une concentration énergétique micro-ondes autour de l'injecteur **10** en présence d'un récipient mais en l'absence de plasma, et permettant l'amorçage de celui-ci, puis un troisième mode résonant (dit mode plasma) permettant d'entretenir le plasma ainsi généré.

Le mode injecteur est un mode résonant correspondant à la cavité **4** associée à l'injecteur **10** (mais en l'absence de récipient et de plasma). Le mode injecteur se caractérise par des noeuds d'énergie répartis suivant un pas égal à la demi-longueur d'onde des micro-ondes (soit un pas de 6,1 cm pour une longueur d'onde de 12,2 cm). Le mode injecteur est dérivé du mode $TM_{020}$

(mode résonant de type transverse magnétique, à concentration d'énergie localisée sur l'axe central de la cavité **4**).

Pour plus de précision au sujet des modes résonants dans les cavités micro-ondes, l'homme du métier pourra consulter l'ouvrage de Mehrdad Mehdizadeh, « Microwave/RF applicators and probes for material heating, sensing, and plasma generation », Elsevier, 2010.

Comme déjà indiqué, les réflexions des micro-ondes sur les parois de la cavité **4** produisent des ondes réfléchies. Ces ondes réfléchies sont captées par l'antenne **24** (qui agit alors comme un récepteur) et converties par celle-ci en signal électrique réfléchi, qui peut circuler dans le câble **25** coaxial.

La présence du signal réfléchi provoque une perte de puissance et la diminution de l'énergie disponible pour générer et entretenir le plasma. Le signal réfléchi peut être mesuré au moyen d'un bolomètre, ou encore au moyen d'un dispositif **26** de mesure de puissance (couramment appelé wattmètre) monté, le long du câble **25** coaxial, entre le générateur **15** et l'antenne **24**.

Le wattmètre **26** est configuré pour mesurer la puissance totale du signal parcourant le câble **25** coaxial. Cette puissance totale est égale à la puissance du signal incident augmentée de la puissance du signal réfléchi.

La puissance délivrée par le générateur **15** étant connue, la mesure de la puissance totale du signal parcourant le câble **25** coaxial permet, par simple soustraction, de calculer la puissance du signal réfléchi. Comme illustré sur la figure 4, le wattmètre **26** est relié à l'unité **14** de contrôle, qui assure la collecte des mesures et les calculs subséquents.

A chaque mode résonant correspond une valeur nominale de puissance réfléchie. Chacune de ces puissances peut être évaluée au moyen d'un logiciel de simulation électromagnétique, par ex. ANSYS HFSS, dans lequel sont introduites les caractéristiques de la cavité **4** et la puissance du signal électrique micro-ondes incident. On peut ainsi établir une base de données contenant, pour le modèle de la cavité **4**, et à puissance incidente donnée, une liste de puissances réfléchies chacune caractéristique d'un mode résonant. En particulier, on peut extraire de cette liste une puissance réfléchie théorique correspondant au mode injecteur.

On peut alors réaliser une procédure de pré-calibrage en fréquence du générateur **15**, au cours de laquelle on cherche une fréquence d'émission des micro-ondes pour laquelle, en l'absence du récipient **2** la cavité **4** associée à l'injecteur **10** résonne suivant le mode injecteur.

La procédure de pré-calibrage, réalisée en l'absence de récipient **2** dans la cavité **4** associée à l'injecteur **10**, et aussi en l'absence de gaz précurseur, comprend au moins un cycle de mesure au cours duquel on alimente la cavité **4** en micro-ondes et on effectue un balayage fréquentiel sur l'ensemble du spectre admissible pour le générateur **15** (ici 2 400 MHz - 2 500 MHz), en vue d'identifier dans ce spectre une fréquence pour laquelle la puissance réfléchie est égale (ou sensiblement égale) à la puissance réfléchie théorique du mode injecteur.

Dans le cas où la procédure de pré-calibrage comprend un unique cycle de mesure, on affecte à la fréquence recherchée (notée F et dite fréquence modale injecteur) la valeur de l'unique fréquence pour laquelle la puissance réfléchie est égale (ou sensiblement égale) à la puissance réfléchie théorique du mode injecteur.

Selon un mode préféré de réalisation, la procédure de pré-calibrage comprend une série de N (N un entier suffisamment important pour obtenir une population statistique significative) cycles de mesures successifs, permettant de collecter une population de N fréquences modales injecteur, notées $F_i$ (i un entier désignant le numéro du cycle, $1 \leq i \leq N$), pour lesquelles, au cours de chaque cycle, la puissance du signal réfléchi est égale (ou sensiblement égale) à la puissance réfléchie théorique du mode injecteur.

On ne retient alors qu'une valeur pour la fréquence recherchée (également notée F et dite fréquence modale injecteur) : la moyenne des fréquences $F_i$ modales primaires :

$$F = \frac{1}{N} \sum_{i=1}^{N} F_i$$

La procédure de pré-calibrage est réalisée pour chaque cavité **4** (et chaque générateur **15** associé) de l'installation **1**. Cette procédure peut être réalisée en usine (c'est-à-dire hors production).

On réalise ensuite une procédure de calibrage en fréquence du générateur **15**, au cours de laquelle :

- on cherche une nouvelle fréquence d'émission des micro-ondes pour laquelle la cavité **4** résonne, cette fois en présence d'un récipient **2**, suivant le mode récipient ;
- on effectue une comparaison avec la fréquence modale injecteur pour en déduire un décalage à celle-ci.

Une première phase (de mesure) de la procédure de calibrage est sensiblement identique à la procédure de pré-calibrage décrite ci-dessus mais en diffère par la présence, dans la cavité **4** (et plus précisément dans l'enceinte **5**), d'un récipient **2** qui, par la nature diélectrique de son matériau, affecte la distribution énergétique de la puissance micro-ondes au sein de la cavité **4**, et donc entraîne un décalage de la fréquence d'émission des micro-ondes pour laquelle la cavité **4** résonne suivant le mode récipient.

Ainsi, la procédure de calibrage comprend, en présence d'un récipient **2** et de l'injecteur **10**, et en l'absence des conditions nécessaires à l'amorçage d'un plasma (par ex. en l'absence de gaz précurseur, ou à débit de gaz réduit, ou à puissance micro-ondes insuffisante, ou encore à vide insuffisant - c'est-à-dire à une pression trop élevée - dans le récipient **2**), au moins un cycle de mesure au cours duquel on alimente la cavité **4** en micro-ondes et on effectue à nouveau un balayage fréquentiel sur l'ensemble du spectre admissible pour le générateur **15** (ici 2 400 MHz - 2 500 MHz), en vue d'identifier dans ce spectre une nouvelle fréquence pour laquelle la puissance réfléchie est égale (ou sensiblement égale) à la puissance réfléchie théorique du mode récipient.

Dans le cas où, comme la procédure de pré-calibrage, la procédure de calibrage comprend un unique cycle de mesure, on affecte à la nouvelle fréquence recherchée (notée F' et dite fréquence modale récipient) la valeur de l'unique fréquence pour laquelle, en présence d'un récipient **2** dans la cavité **4**, la puissance réfléchie est égale (ou sensiblement égale) à la puissance réfléchie théorique du mode récipient.

On calcule alors le décalage, noté D, de la fréquence modale récipient à la fréquence modale injecteur, égal à leur différence :

$$D = F' - F$$

Selon un mode préféré de réalisation, la procédure de calibrage comprend plutôt une série de P (P un entier, qui peut être égal à N) cycles de mesures successifs, permettant de collecter une population de P fréquences modales récipient, notées $F'_i$ (i un entier désignant le numéro du cycle, $1 \leq i \leq P$), pour lesquelles, au cours de chaque cycle, la puissance du signal réfléchi est égale (ou sensiblement égale), en présence d'un récipient **2** dans la cavité **4**, à la puissance réfléchie théorique du mode récipient.

Dans ce cas, on calcule pour chaque fréquence $F'_i$ son décalage, noté $D_i$, à la fréquence F modale injecteur, égal à la valeur absolue de leur différence, ainsi que le décalage moyen, noté comme précédemment D, des décalages $D'_i$ :

$$D_i = F'_i - F$$

$$D = \frac{1}{P} \sum_{i=1}^{P} D_i = \frac{1}{P} \sum_{i=1}^{P} (F'_i - F)$$

Selon un mode particulier de réalisation, on peut également, dans ce cas, calculer l'écart type, noté $\sigma$, de la population des décalages $D_i$ au décalage D moyen :

$$\sigma = \sqrt{\frac{1}{P}\sum_{i=1}^{P}(D_i - D)^2}$$

La procédure de calibrage est réalisée pour chaque cavité 4 (et chaque générateur 15 associé) de l'installation 1.

Les procédures de pré-calibrage et de calibrage permettent de sélectionner, parmi l'ensemble du spectre micro-ondes admis par le générateur 15 (ici 2 400 MHz - 2 500 MHz), une gamme de fréquences micro-ondes (dite gamme efficace d'amorçage) susceptibles d'exciter la cavité 4 suivant le mode récipient, et donc, grâce à la concentration de puissance que ce mode génère au cœur du récipient 2, d'amorcer le plasma dans le gaz précurseur.

Lorsque les procédures de pré-calibrage et de calibrage ne comprennent qu'un unique cycle de mesure, la gamme efficace d'amorçage est :

[F - |D|;F + |D|]

Lorsque les procédures de pré-calibrage et de calibrage comprennent plusieurs (respectivement N et P) cycles de mesures, la gamme efficace d'amorçage est :

[F + |D| - 3$\sigma$; F + |D| + 3$\sigma$]

Il est ensuite prévu une procédure de démarrage, qui vise à identifier, parmi la gamme efficace d'amorçage, une fréquence, dite de démarrage et notée $F_0$, permettant d'amorcer et d'entretenir un plasma dans le récipient 2.

On suppose que le poste 3 de traitement est en ordre de marche, c'est-à-dire qu'un récipient 2 à traiter est présent dans l'enceinte 5, qu'un vide poussé y a été fait, qu'un vide moyen a été réalisé dans l'enceinte 5, que l'injecteur 10 est en place dans le récipient 2 et que le gaz précurseur est prêt à être injecté dans le récipient 2.

Selon un premier mode de réalisation, On injecte alors le gaz précurseur dans le récipient 2, on met en route le générateur 15 et on règle la fréquence d'émission des micro-ondes (via l'unité 14 de contrôle agissant sur le variateur 22 de fréquence) à une valeur quelconque choisie dans la gamme efficace d'amorçage (par exemple F + |D|).

Puis la fréquence d'émission des micro-ondes est alors réglée par l'unité 14 de contrôle, via le variateur 22 de fréquence, jusqu'à ce que l'intensité du plasma déduite de la mesure effectuée par le capteur 13 dépasse un seuil prédéterminé, témoignant de la présence d'un plasma dans le récipient 2. Ce seuil, mémorisé dans l'unité 14 de contrôle, est par exemple de valeur nulle ou sensiblement nulle (ce qui correspond à l'obscurité dans la cavité 4).

Le plasma résulte de la décomposition moléculaire du gaz précurseur par l'énergie micro-ondes concentrée au cœur du récipient 2 grâce au mode récipient.

La décomposition moléculaire du gaz précurseur (en l'espèce de l'acétylène) produit une soupe d'espèces volatiles variées de type $C_xH_y$, où x et y sont des réels avec x≥0 et y≥0, dont une partie au moins est ionique.

La décomposition moléculaire du gaz précurseur produit des photons notamment dans le domaine visible du spectre électromagnétique, ce qui rend le plasma lumineux et donc détectable dans ce domaine. Il s'agit cependant d'un plasma dit « froid » (ou de faible énergie), dans lequel les espèces volatiles issues de la décomposition moléculaire du gaz précurseur demeurent à température ambiante.

La nature au moins partiellement ionique du plasma lui confère une conductivité électrique non nulle qui, se couplant aux champs électrique et magnétique régnant dans l'enceinte 5, affecte la distribution spatiale de l'énergie micro-ondes en raison de la variation de permittivité diélectrique du milieu dans lequel se propagent les micro-ondes. Il peut en résulter une extinction du plasma si la distribution spatiale de l'énergie micro-ondes est affectée au point que la densité énergétique au cœur du récipient 2 est insuffisante pour entretenir le plasma.

Cependant, après que les espèces $C_xH_y$ du plasma se sont déposées sur la paroi interne du récipient 2 (contribuant ainsi à la génération d'une couche mince de carbone amorphe hydrogéné), ou ont été pompées hors du récipient 2 par le circuit primaire de vide, le gaz précurseur redevient prépondérant dans le récipient 2 et la distribution spatiale de l'énergie peut recouvrer sa géométrie initiale, correspondant au mode résonant récipient, ce qui permet de réamorcer le plasma.

Les amorçages et extinctions successifs du plasma interviennent rapidement (en moins d'un dixième de seconde), de sorte qu'on constate à l'aide du capteur 13 un phénomène de clignotement dans le récipient 2. Lorsque le capteur 13 est un capteur de luminosité, il détecte successivement une luminosité positive (à l'amorçage du plasma) et une luminosité nulle (à son extinction).

Un tel clignotement est à proscrire car, bien qu'il n'empêche pas, en théorie, le dépôt des espèces sur la paroi interne du récipient 2 (et donc la formation de la couche barrière), le temps de traitement requis est beaucoup trop long pour une production à cadence industrielle. La couche déposée peut en outre présenter des inhomogénéités, dues à une mauvaise répartition des espèces dans le récipient, résultant de la durée insuffisante du plasma amorcé à chaque clignotement.

On comprend par conséquent qu'il n'est pas suffisant de trouver parmi la gamme efficace d'amorçage une valeur de fréquence qui permette d'initier le plasma, mais qu'il est nécessaire ensuite d'adapter cette fréquence pour qu'elle permette également d'entretenir le plasma.

A cet effet, la procédure de démarrage comprend une phase de calage au cours de laquelle l'unité 14 de contrôle commande un balayage fréquentiel, via le variateur 22 de fréquence, à partir de la première valeur (par ex. par incrément de 1 MHz ou de 0,1 MHz), jusqu'à l'obtention d'une fréquence permettant d'entretenir le plasma. Il est envisageable de s'en tenir à cette approche, et de mémoriser cette fréquence en tant que fréquence d'entretien du plasma.

Mais cette approche peut paraître insuffisante, car on peut souhaiter trouver, au sein de la gamme efficace d'amorçage, une valeur de fréquence permettant non seulement d'entretenir le plasma, mais également de minimiser le temps de traitement, à l'issue duquel l'épaisseur de la couche qui s'est déposée sur la paroi interne du récipient **2** est présumée suffisante (de ordre d'une dizaine à quelques centaines de nm - rappelons que 1 nm = $10^{-9}$ m) pour procurer l'effet barrière désiré.

A cet effet, il est nécessaire de maximiser la densité d'énergie au cœur du récipient **2**, ce qui revient à minimiser la puissance réfléchie.

En pratique, la procédure de démarrage comprend dans ce cas une phase de calage (différente de la précédente) au cours de laquelle l'unité **14** de contrôle commande un balayage fréquentiel de l'ensemble de la gamme efficace d'amorçage, (par ex. de la borne minimale à la borne maximale), par incrément prédéfini (par ex. de 1 MHz ou de 0,1 MHz), avec, pour chaque fréquence, un temps de mesure prédéterminé (par ex. de quelques dizaines de millisecondes).

Pour chaque fréquence, l'unité **14** de contrôle relève, via le wattmètre **26** et le capteur **13**, respectivement la puissance réfléchie (à minimiser) et l'intensité du plasma dans la cavité **4** (qui doit être strictement positive pendant le temps de mesure).

Les valeurs de puissance réfléchie et d'intensité énergétique du plasma sont mémorisées par l'unité **14** de contrôle. Puis celle-ci sélectionne, à la fin du cycle de balayage, la fréquence qui, à intensité énergétique positive, engendre la puissance réfléchie la plus faible. Cette fréquence est alors mémorisée en tant que fréquence $F_0$ d'entretien du plasma par l'unité **14** de contrôle.

Une fois définie la fréquence $F_0$ pour chaque cavité **4** (c'est-à-dire pour chaque générateur **15**), le processus de production (c'est-à-dire de traitement des récipients **2** à cadence industrielle) dans l'installation **1** peut démarrer, l'unité **14** de contrôle réglant pour chaque générateur **15** la fréquence d'émission des micro-ondes à la valeur $F_0$ prédéfinie pour celui-ci.

On peut en outre prévoir, soit au cours de la production, soit au cours d'une phase de pré-production (à l'issue de laquelle les récipients **2**, qui peuvent présenter des défauts de traitement, ne sont pas destinés à la vente), une procédure de réglage au cours de laquelle peuvent être ajustés :

- la fréquence d'émission des micro-ondes pour adapter le mode résonant dans la cavité **4** aux variations d'intensité du plasma - cette variation de fréquence peut être considérée comme directement proportionnelle à l'intensité du plasma (déduite des mesures réalisées par le capteur **13**) ;

- le degré de vide dans le récipient **2** ;
- le débit de gaz précurseur ;
- la puissance du générateur **15**.

De ces quatre paramètres dépend en effet la vitesse de croissance de la couche barrière au cours du traitement. En les faisant varier, il est possible d'augmenter la cadence de production en augmentant la vitesse de croissance de la couche barrière.

La vitesse de croissance de la couche barrière peut être mesurée par la variation de l'intensité énergétique du plasma mesurée au cours du traitement par le capteur **13**. En effet, la couche barrière assombrit progressivement la paroi interne du récipient **2**, de sorte que la luminosité mesurée diminue au cours du traitement, au fur et à mesure de la croissance de la couche barrière.

On peut, à partir d'une série de mesures de luminosité effectuées pendant le traitement d'un récipient **2** et mémorisées par l'unité **14** de contrôle, construire par interpolation (notamment polynomiale) une courbe des variations de la luminosité au cours du traitement. Partant de la valeur nulle (avant l'amorçage du plasma), la courbe montre un pic (correspondant à l'amorçage du plasma) suivi d'une décroissance linéaire (correspondant à la croissance de la couche barrière et à l'assombrissement progressif de la paroi du récipient **2**).

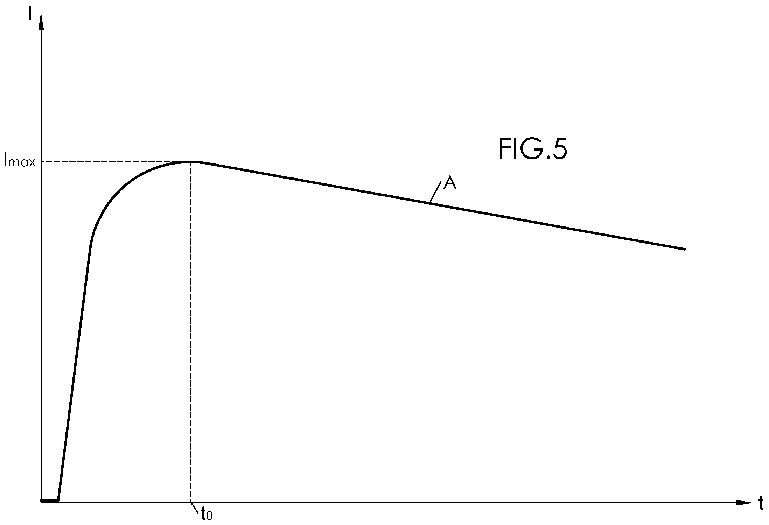

On a tracé sur la figure 5 une courbe illustrant les variations de la luminosité induite par le plasma dans la cavité **5**. Cette courbe montre un pic de luminosité d'une valeur $I_{max}$ à un instant $t_0$, puis une pente A ayant un taux d'accroissement (négatif).

Comme nous l'avons vu, la fréquence d'émission des micro-ondes a une incidence sur la densité énergétique micro-ondes au sein de la cavité **4**, et influe par conséquent sur l'intensité du plasma (notamment à l'amorçage) et donc sur la vitesse de croissance de la couche barrière. Cependant, la fonction liant, tous paramètres égaux par ailleurs, la fréquence d'émission des micro-ondes à la vitesse de croissance de la couche barrière est à ce jour inconnue, et seule des essais permettent d'optimiser cette dernière.

On a déjà décrit la manière dont peut être réglée la fréquence d'émission des micro-ondes (par l'unité **14** de contrôle via le variateur **22** de fréquence).

L'unité **14** de contrôle peut être programmée pour commander (via le variateur **22** de fréquence), en partant de la fréquence $F_0$, un ajustement de la fréquence d'émission des micro-ondes jusqu'à obtenir une fréquence $F'_0$ corrigée maximisant l'intensité lumineuse $I_{max}$ à l'amorçage et/ou maximisant la vitesse de croissance de la couche barrière (en faisant varier la pente A). Cet ajustement peut être effectué de manière fine (par ex. par variations incrémentales de l'ordre de 1 à 10 kHz) pour conserver une puissance réfléchie minimale et éviter d'affecter la distribution énergétique dans la cavité **4** au point que le plasma ne s'éteigne ou ne se mette à clignoter.

Augmenter le degré de vide dans le récipient **2** et/ou le débit du gaz précurseur permet d'augmenter la densité de gaz précurseur dans le récipient **2** (et donc l'intensité énergétique du plasma ainsi que la vitesse de croissance de la couche barrière).

Pour permettre un réglage du degré de vide dans le récipient **2**, le poste **3** de traitement comprend un capteur **27** de pression monté dans le couvercle **6** et débouchant dans la tuyère **8** (où la pression est égale à celle régnant dans le récipient **2**), et la pompe **7** à vide est asservie à l'unité **14** de contrôle qui peut ainsi en régler le débit.

L'unité **14** de contrôle peut être programmée pour commander (via le débit de la pompe **7** à vide) un ajustement du degré de vide dans le récipient **2** jusqu'à obtenir une valeur de débit maximisant l'intensité lumineuse $I_{max}$ à l'amorçage et/ou maximisant la vitesse de croissance de la couche barrière.

Pour permettre un réglage du débit de gaz précurseur, l'électrovanne **12** du dispositif **9** d'injection est asservie à l'unité **14** de contrôle qui en commande l'ouverture.

L'unité **14** de contrôle peut être programmée pour commander (via l'électrovanne **12**) un ajustement du débit de gaz précurseur jusqu'à obtenir une valeur de débit maximisant l'intensité lumineuse $I_{max}$ à l'amorçage et/ou maximisant la vitesse de croissance de la couche barrière.

Augmenter la puissance du signal micro-ondes délivré par le générateur **15** permet également d'augmenter l'intensité du plasma et la vitesse de croissance de la couche barrière.

La puissance peut être ajustée via un variateur de puissance intégré au générateur **15**, et commandé par l'unité **14** de contrôle. L'unité **14** de contrôle peut ainsi être programmée pour commander un ajustement de la puissance des micro-ondes délivrées par le générateur **15** pour augmenter l'intensité lumineuse à l'amorçage et/ou la vitesse de croissance de la couche barrière.

D'un point de vue pratique, le générateur **15** peut être équipé d'un unique port d'entrée/sortie sur lequel peut être branché un bus **28** (par ex. de type universel en série ou USB) pour le raccordement de l'unité **14** de contrôle.

Dans ce cas, la distribution des signaux de commande est réalisée en aval du port d'entrée/sortie par une électronique de commande (typiquement une carte mère) du générateur **15**, pour affecter au variateur **22** de fréquence le signal de commande fréquentiel, et au variateur de puissance le signal de commande de puissance. Ces signaux peuvent être transmis par l'unité **14** de contrôle sur le même bus **28** en étant par exemple entrelacés au moyen d'un algorithme de multiplexage temporel ou TDM (time division multiplexing).

L'utilisation d'un générateur à état solide pour amorcer et entretenir un plasma dans le traitement des récipients par dépôt chimique en phase vapeur procure plusieurs avantages.

Premièrement, la possibilité de réglage fréquentiel du générateur à état solide évite de pénibles essais d'appariement entre générateur (du type magnétron) et cavité, au bénéfice de la simplification de construction et d'assemblage des machines de traitement des récipients par plasma. Deuxièmement, le réglage fréquentiel automatique permet de générer de manière plus simple, plus rapide et plus certaine un mode résonant favorable à l'amorçage et à l'entretien du plasma, au bénéfice de la fiabilité de la machine. Troisièmement, le réglage fréquentiel permet, par sélection des modes résonants les plus efficaces, d'améliorer la qualité du traitement par plasma des récipients tout en évitant les phénomènes de clignotement.

**Revendications**

1. Installation (**1**) pour le dépôt chimique en phase vapeur assisté par plasma, sur une paroi interne d'un récipient (**2**) en polymère, d'une couche barrière mince, qui comprend :

   - une cavité (**4**) conductrice ;
   - une enceinte (**5**) montée dans la cavité (**4**) ;
   - un dispositif (**9**) d'injection d'un gaz précurseur dans l'enceinte (**5**) ;
   - un générateur (**15**) de micro-ondes ;
   - un dispositif (**24**) de diffusion des micro-ondes dans l'enceinte (**5**), relié au générateur (**15**) de micro-ondes, pour exciter et entretenir un plasma dans le gaz précurseur ;
   - un capteur (**13**) disposé de façon à mesurer une grandeur physique caractérisant l'intensité énergétique du plasma produit dans le récipient (**2**)

   cette installation étant **caractérisée :**

   - **en ce que** le générateur (**15**) de micro-ondes est un générateur à état solide, équipé d'un variateur (**22**) de fréquence d'émission des micro-ondes ;
   - **en ce qu'**elle comprend une unité (**14**) de contrôle reliée au capteur (**13**) et au générateur (**15**) de micro-ondes, cette unité (**14**) de contrôle étant programmée pour faire varier la fréquence d'émission des micro-ondes, par l'intermédiaire du variateur (**22**) de fréquence, lors d'une phase de calibrage et lors d'une phase de démarrage :
   - lors de la phase de calibrage, le récipient étant monté dans l'enceinte et ne contenant pas de plasma, l'unité de contrôle est programmée pour sélectionner une gamme de fréquences efficaces d'amorçage pour laquelle une puissance réfléchie sur le dispositif (**24**) de diffusion des micro-ondes est sensiblement égale à une puissance réfléchie théorique pour la cavité 4,
   - lors de la phase de démarrage, l'unité de contrôle est programmée pour ajuster la fréquence d'émission des micro-ondes, parmi la gamme de fréquences efficaces d'amorçage et en fonction de la valeur de la grandeur physique caractérisant l'intensité énergétique mesurée par le capteur (**13**).

2. Installation (**1**) selon la revendication 1, **caractérisée en ce que** le capteur (**13**) est un capteur de luminosité dirigé vers l'enceinte (**5**) afin de mesurer la luminosité au travers de la paroi de l'enceinte (**5**) et celle du récipient (**2**).

3. Installation (**1**) selon la revendication 1, **caractérisée en ce que** le capteur (**13**) associé à l'enceinte (**5**) est un spectromètre agencé pour mesurer les concentrations massiques des différentes espèces contenues dans le plasma produit dans le récipient (**2**).

4. Installation (**1**) selon la revendication 1, **caractérisée en ce que** le capteur (**13**) associé à l'enceinte (**5**) est un capteur de la pression du plasma régnant dans le récipient (**2**).

5. Installation (**1**) selon l'une des revendications 1 à 4, **caractérisée en ce que** le dispositif (**24**) de diffusion des micro-ondes se présente sous forme d'une antenne.

6. Installation (**1**) selon la revendication 5, **caractérisée en ce que** l'antenne (**24**) s'étend au travers de la cavité (**4**) et fait saillie dans celle-ci.

7. Installation (**1**) selon la revendication 5 ou la revendication 6, **caractérisée en ce que** l'antenne (**24**) forme une boucle dans la cavité (**4**).

8. Installation (**1**) selon la revendication 7, **caractérisée en ce que** les dimensions de la boucle formée par l'antenne (**24**) sont du même ordre de grandeur que la demi-longueur d'onde des micro-ondes produites par le générateur (**15**).

9. Installation selon l'une des revendications 1 à 8, **caractérisée en ce que** le dispositif (**24**) de diffusion des micro-ondes est relié au générateur (**2**) par un câble (**25**) coaxial.

10. Procédé de réglage d'une installation (**1**) selon l'une des revendications 1 à 9, qui comprend les opérations consistant à :

  - introduire un récipient (**2**) dans l'enceinte (**5**),
  - injecter le gaz précurseur dans le récipient (**2**),
  - générer dans l'enceinte (**5**), au moyen du générateur (**15**) de micro-ondes, un champ électromagnétique à une fréquence d'émission prédéterminée de façon à exciter un plasma dans le gaz précurseur,
  - mesurer une grandeur physique caractérisant l'intensité énergétique du plasma produit dans l'enceinte (**5**) au moyen du capteur (**13**) ;
  - lors d'une phase de calibrage au cours de laquelle le récipient est monté dans l'enceinte et ne contient pas de plasma, l'unité de contrôle sélectionne une gamme de fréquences efficaces d'amorçage pour laquelle une puissance réfléchie sur le dispositif (**24**) de diffusion des micro-ondes est sensiblement égale à une puissance réfléchie théorique pour la cavité 4,
  - lors d'une phase de démarrage, tant que la grandeur physique caractérisant l'intensité énergétique du plasma produit dans l'enceinte (**5**) diffère d'une valeur de référence prédéterminée, ajuster la fréquence d'émission des micro-ondes parmi ladite gamme de fréquences efficaces d'amorçage au moyen de l'unité (**14**) de contrôle agissant sur le variateur (**22**) de fréquence.

11. Procédé de réglage selon la revendication 10, **caractérisé en ce que** la grandeur physique mesurée est proportionnelle à la valeur de l'intensité énergétique.

12. Procédé de réglage selon la revendication 11, **caractérisé en ce que** la grandeur physique mesurée est la luminosité du plasma.

13. Procédé de réglage selon la revendication 11, **caractérisé en ce que** la grandeur physique mesurée est la concentration massique des espèces contenues dans le plasma.

14. Procédé de réglage selon la revendication 10, **caractérisé en ce que** la grandeur physique mesurée est inversement proportionnelle à l'intensité énergétique.

15. Procédé de réglage selon la revendication 14, **caractérisé en ce que** la grandeur physique mesurée est la pression régnant dans le récipient (**2**).

**Patentansprüche**

1. Anlage (1) zur plasmaunterstützten chemischen Dampfabscheidung einer dünnen Sperrschicht auf eine Innenwand eines Behälters (2) aus Polymermaterial, die enthält:

  - einen leitenden Hohlraum (4);
  - ein in den Hohlraum (4) montiertes Gehäuse (5);
  - eine Vorrichtung (9) zum Einspeisen eines Vorläufergases in das Gehäuse (5);
- einen Mikrowellengenerator (15);
- eine mit dem Mikrowellengenerator (15) verbundene Vorrichtung (24) zur Verbreitung der Mikrowellen im Gehäuse (5), um ein Plasma im Vorläufergas anzuregen und aufrechtzuerhalten;
- einen Sensor (13), der so angeordnet ist, dass er eine physikalische Größe misst, die die Energieintensität des im Behälter (2) erzeugten Plasmas kennzeichnet;

wobei diese Anlage **dadurch gekennzeichnet ist:**

- **dass** der Mikrowellengenerator (15) ein Festkörpergenerator ist, der mit einem Sendefrequenzumrichter (22) der Mikrowellen ausgestattet ist;
- **dass** sie eine mit dem Sensor (13) und mit dem Mikrowellengenerator (15) verbundene Steuereinheit (14) enthält, wobei diese Steuereinheit (14) programmiert ist, die Sendefrequenz der Mikrowellen mittels des Frequenzumrichters (22) während einer Kalibrierungsphase und während einer Startphase zu variieren:
- in der Kalibrierungsphase, wobei der Behälter in das Gehäuse montiert ist und kein Plasma enthält, ist die Steuereinheit programmiert, um einen Bereich wirksamer Zündfrequenzen auszuwählen, in dem eine auf die Vorrichtung (24) zur Verbreitung der Mikrowellen reflektierte Leistung im Wesentlichen gleich einer theoretischen reflektierten Leistung für den Hohlraum 4 ist,
- in der Startphase ist die Steuereinheit programmiert, um die Sendefrequenz der Mikrowellen im Bereich wirksamer Zündfrequenzen und abhängig vom Wert der physikalischen Größe anzupassen, die die vom Sensor (13) gemessene Energieintensität kennzeichnet.

2. Anlage (1) nach Anspruch 1, **dadurch gekennzeichnet, dass** der Sensor (13) ein Leuchtstärkesensor ist, der auf das Gehäuse (5) gerichtet ist, um die Leuchtstärke durch die Wand des Gehäuses (5) und diejenige des Behälters (2) hindurch zu messen.

3. Anlage (1) nach Anspruch 1, **dadurch gekennzeichnet, dass** der dem Gehäuse (5) zugeordnete Sensor (13) ein Spektrometer ist, das eingerichtet ist, um die Massenkonzentrationen der verschiedenen im im Behälter (2) erzeugten Plasma enthaltenen Spezies zu messen.

4. Anlage (1) nach Anspruch 1, **dadurch gekennzeichnet, dass** der dem Gehäuse (5) zugeordnete Sensor (13) ein Sensor des Drucks des im Behälter (2) herrschenden Plasmas ist.

5. Anlage (1) nach einem der Ansprüche 1 bis 4, **dadurch gekennzeichnet, dass** die Vorrichtung (24) zur Verbreitung der Mikrowellen in Form einer Antenne vorliegt.

6. Anlage (1) nach Anspruch 5, **dadurch gekennzeichnet, dass** die Antenne (24) sich durch den Hohlraum (4) hindurch erstreckt und in diesen vorsteht.

7. Anlage (1) nach Anspruch 5 oder Anspruch 6, **dadurch gekennzeichnet, dass** die Antenne (24) im Hohlraum (4) eine Schleife bildet.

8. Anlage (1) nach Anspruch 7, **dadurch gekennzeichnet, dass** die Abmessungen der von der Antenne (24) geformten Schleife von der gleichen Größenordnung sind wie die halbe Wellenlänge der vom Generator (15) erzeugten Mikrowellen.

9. Anlage nach einem der Ansprüche 1 bis 8, **dadurch gekennzeichnet, dass** die Vorrichtung (24) zur Verbreitung der Mikrowellen durch ein Koaxialkabel (25) mit dem Generator (2) verbunden ist.

10. Verfahren zu Einstellen einer Anlage (1) nach einem der Ansprüche 1 bis 9, das die Vorgänge enthält, die darin bestehen:

- einen Behälters (2) in das Gehäuse (5) einzuführen,
- das Vorläufergas in den Behälter (2) einzuspeisen,
- im Gehäuse (5) mittels des Mikrowellengenerators (15) ein elektromagnetisches Feld mit einer vorbestimmten Sendefrequenz zu erzeugen, um ein Plasma im Vorläufergas anzuregen,
- eine physikalische Größe, die die Energieintensität des im Gehäuse (5) erzeugten Plasmas kennzeichnet, mittels des Sensors (13) zu messen;
- in einer Kalibrierungsphase, während der der Behälter in das Gehäuse montiert ist und kein Plasma enthält, wählt die Steuereinheit einen Bereich wirksamer Zündfrequenzen aus, in dem eine auf die Vorrichtung (24) zur Verbreitung der Mikrowellen reflektierte Leistung im Wesentlichen gleich einer theoretischen reflektierten Leistung für den Hohlraum 4 ist,
- in einer Startphase, so lange die die Energieintensität des im Gehäuse (5) erzeugten Plasmas kennzeichnende physikalische Größe sich von einem vorbestimmten Bezugswert unterscheidet, die Sendefrequenz der Mikrowellen aus dem Bereich wirksamer Zündfrequenzen mittels der Steuereinheit (14) anzupassen, die auf den Frequenzumrichter (22) einwirkt.

**11.** Einstellverfahren nach Anspruch 10, **dadurch gekennzeichnet, dass** die gemessene physikalische Größe proportional zum Wert der Energieintensität ist.

**12.** Einstellverfahren nach Anspruch 11, **dadurch gekennzeichnet, dass** die gemessene physikalische Größe die Leuchtstärke des Plasmas ist.

**13.** Einstellverfahren nach Anspruch 11, **dadurch gekennzeichnet, dass** die gemessene physikalische Größe die Massenkonzentration der im Plasma enthaltenen Spezies ist.

**14.** Einstellverfahren nach Anspruch 10, **dadurch gekennzeichnet, dass** die gemessene physikalische Größe zur Energieintensität umgekehrt proportional ist.

**15.** Einstellverfahren nach Anspruch 14, **dadurch gekennzeichnet, dass** die gemessene physikalische Größe der im Behälter (2) herrschende Druck ist.

**Claims**

**1.** Facility (1) for the plasma-enhanced chemical vapour deposition, on an internal wall of a container (2) made of polymer, of a thin barrier layer, comprising:

- a conductive cavity (4);
- an enclosure (5) mounted inside the cavity (4);
- a device (9) for injecting a precursor gas into the enclosure (5);
- a microwave generator (15);
- a device (24) for diffusing the microwaves inside the enclosure (5), which device is connected to the microwave generator (15), to excite and sustain a plasma in the precursor gas;
- a sensor (13) arranged in such a way as to measure a physical parameter that characterizes the energy intensity of the plasma produced in the container (2)

this facility being **characterized:**

- **in that** the microwave generator (15) is a solid state generator equipped with a variator (22) that varies the microwave emission frequency;
- **in that** it comprises a control unit (14) connected to the sensor (13) and to the microwave generator (15), this control unit (14) being programmed to vary the microwave emission frequency, by means of the frequency variator (22), during a calibration phase and during a start-up phase:
- during the calibration phase, with the container being mounted inside the enclosure and not containing plasma, the control unit is programmed to select a range of effective initiation frequencies for which a reflected power on the microwave diffusion device (24) is substantially equal to a theoretical reflected power for the cavity (4),
- during the start-up phase, the control unit is programmed to adjust the microwave emission frequency, among the range of effective initiation frequencies and as a function of the value of the physical parameter that characterizes the energy intensity, as measured by the sensor (13).

**2.** Facility (1) according to Claim 1, **characterized in that** the sensor (13) is a luminance sensor aimed towards the enclosure (5) so as to measure the luminance through the wall of the enclosure (5) and that of the container (2).

**3.** Facility (1) according to Claim 1, **characterized in that** the sensor (13) associated with the enclosure (5) is a spectrometer designed to measure the mass concentrations of the various species contained in the plasma produced in the container (2).

**4.** Facility (1) according to Claim 1, **characterized in that** the sensor (13) associated with the enclosure (5) is a pressure sensor sensing the plasma pressure prevailing in the container (2).

**5.** Facility (1) according to one of Claims 1 to 4, **characterized in that** the microwave diffusion device (24) takes the form of an antenna.

**6.** Facility (1) according to Claim 5, **characterized in that** the antenna (24) extends through the cavity (4) and projects there into.

**7.** Facility (1) according to Claim 5 or Claim 6, **characterized in that** the antenna (24) forms a loop in the cavity (4).

**8.** Facility (1) according to Claim 7, **characterized in that** the dimensions of the loop formed by the antenna (24) are of the same order of magnitude as the half-wavelength of the microwaves produced by the generator (15).

**9.** Facility according to one of Claims 1 to 8, **characterized in that** the microwave diffusion device (24) is connected to the generator (2) by a coaxial cable (25).

**10.** Adjustment method for adjusting a facility (1) according to one of Claims 1 to 9, which comprises the operations of:

- introducing a container (2) into the enclosure (5),
- injecting the precursor gas into the container (2),
- generating, inside the enclosure (5), by means of the microwave generator (15), an electromagnetic field at an emission frequency that is predetermined so as to excite a plasma in the precursor gas,
- measuring a physical parameter that characterizes the energy intensity of the plasma produced in the enclosure (5) by means of the sensor (13);
- during a calibration phase during the course of which the container is mounted in the enclosure and does not contain plasma, the control unit selects a range of effective initiation frequencies for which range a reflected power on the microwave diffusion device (24) is substantially equal to a theoretical reflected power for the cavity (4),
- during a start-up phase, as long as the physical parameter characterizing the energy intensity of the plasma produced in the enclosure (5) differs from a predetermined reference value, adjusting the microwave emission frequency within said range of effective initiation frequencies using the control unit (14) acting on the frequency variator (22).

11. Adjusting method according to Claim 10, **characterized in that** the physical parameter measured is proportional to the energy intensity value.

12. Adjusting method according to Claim 11, **characterized in that** the physical parameter measured is the luminance of the plasma.

13. Adjusting method according to Claim 11, **characterized in that** the physical parameter measured is the mass concentration of the species contained in the plasma.

14. Adjusting method according to Claim 10, **characterized in that** the physical parameter measured is inversely proportional to the energy intensity.

15. Adjusting method according to Claim 14, **characterized in that** the physical parameter measured is the pressure prevailing in the container (2) .

FIG.2

FIG.1

FIG.3

FIG.4

FIG.5

**EP 3 292 229 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- EP 1068032 A
- JP 2006336095 A
- WO 2012146870 A
- WO 02007006977 A
- US 20100007100 A
- US 20100206232 A

### Littérature non-brevet citée dans la description

- l'Encyclopédie Ullmann de l'industrie chimique. vol. A26, 720
- **HERBERT L. KRAUS et al.** Solid State Radio Engineering. John Wiley & Sons, 1980
- **STEPHEN F. ADAM.** Microwave theory and applications. *Englewood cliffs,* 1969
- **OWEN E. MAYNARD.** Solid State SPS Microwave Generation and Transmission Study. *NASA Scientific and technical,* 1980
- **MEHRDAD MEHDIZADEH.** Microwave/RF applicators and probes for material heating, sensing, and plasma generation. Elsevier, 2010